# EUROPEAN PATENT APPLICATION

(11) **EP 4 560 653 A1**
(43) Date of publication of application: **28.05.2025**
(21) Application number: 23211841.4
(22) Date of filing: 23.11.2023
(51) Int. Cl.: H01B 17/30, F16L 5/02, F16L 5/10, H01R 13/52, H02G 3/22, H05K 5/02

(54) **WIRE SEAL AND METHOD FOR SEALING A WIRE FEED-THROUGH**

(71) Applicant: TE Connectivity India Private Limited, Bangalore, Karnataka 560066 (IN); TE Connectivity Belgium B.V., 8020 Oostkamp (BE); TE Connectivity Solutions GmbH, 8200 Schaffhausen (CH)
(72) Inventor: ROOPESH, Beekanahalli Shivaprakash, 560066 Bangalore (IN); SHOBINTH, Nikshep Kargadde, 560066 Bangalore (IN); SINGH, Kiranpal, 560066 Bangalore (IN); RAVINTHIRAN, Manivasakan, 560066 Bangalore (IN); NATARAJAN, Natarajan, 560066 Bangalore (IN); BOUDRIE, Valentin, 8020 Oostkamp (BE); SCHINDEL, Rainer, 64625 Bensheim (DE)
(74) Representative: Grünecker Patent- und Rechtsanwälte PartG mbB

(57) **Abstract**

The invention relates to a wire seal (101, 501, 901, 1001) for the sealing of a feed-through (801) of one or more wires (151, 551, 951, 1051) through a wall (800), in particular for the sealing of a feed-through of one or more sensor wires through an electric machine frame wall, the wall (800) separating a first environment (E1) and a second environment (E2). The wire seal (101, 501, 901, 1001) is characterized in that a slot (113, 713, 913) is formed in the wire seal (101, 501, 901, 1001), and the first side (115a, 515a, 1015a) of the wire seal housing (103, 503, 903, 1003) comprises an opening (117, 717) to the slot (113, 713, 913), the opening (117, 717) connecting the first environment (E1) and the slot (113, 713, 913), the wire seal (101, 501, 901, 1001) further comprising a receptacle (105, 515, 905, 1005) positioned in the slot (113, 713, 913) and configured to hold an electronic circuit assembly (111, 511). The invention also relates to a method for sealing a wire feed-through in an electric machine frame wall.

## Description

The present invention relates to a wire seal for the sealing of a feed-through of one or more wires through a wall, in particular the sealing of a feed-through of one or more sensor wires through an electric machine frame wall. The invention also relates to a method for sealing a wire feed-through in an electric machine frame wall.

It is known in the art to feed wires through a wall separating a first environment and a second environment, for example a dry environment and a liquid environment, and to seal the wire feed-through with a wire seal.

For instance, the monitoring of the operation of an electric machine typically involves diagnostic and/or monitoring means that comprise sensing elements installed in an oil-submerged environment, in particular in the vicinity of the stator, whereby the sensing elements are wired to a switching device located in a comparatively dry environment. To collect the sensing signals, sensor wires are fed through an electric machine frame wall separating the oil-submerged environment and the comparatively dry environment, and a synthetic rubber wire seal seals the wire feed-through in the electric machine frame wall.

However, known wire seals may have insufficient sealing performance in view of increasing vibration resistance, corrosion resistance, pressure resistance, and/or temperature resistance requirements. In addition, even though the wire seal seals the wire feed-through in the electric machine frame wall, chemical contaminants such as oil splashes may still occur in the comparatively dry environment. Thus, electronic devices present in the comparatively dry environment require protective encapsulation to prevent damage.

It is therefore an object of the present invention to provide a sealing solution with improved sealing performance and, in particular, a sealing solution that allows for further protection of electronic devices present in a first environment.

The above-outlined object of the invention is achieved with a wire seal for the sealing of a feed-through of one or more wires through a wall, in particular for the sealing of a feed-through of one or more sensor wires through an electric machine frame wall, the wall separating a first environment and a second environment, according to claim 1.

The wire seal comprises a wire seal housing having a first side configured to interface the first environment, and a second side configured to interface the second environment, wherein the wire seal housing comprises one or more wire ducts connecting the first environment and the second environment and configured for the feed-through of at least one respective wire.

The wire seal is characterized in that a slot is formed in the wire seal, and the first side of the wire seal housing comprises an opening to the slot, the opening connecting the first environment and the slot, and in that the wire seal further comprises a receptacle positioned in the slot and configured to hold an electronic circuit assembly.

According to the wire seal of the invention, the opening to the slot can be used to position the receptacle inside the slot formed in the wire seal. In this way, an electronic circuit assembly can be held in the receptacle, further protecting the electronic circuit assembly from environmental risk factors present in the first environment. Therefore, when an electronic circuit assembly is needed in the first environment, for example when a microchip or digital memory device is required in a dry environment of an electric machine frame, said electronic circuit assembly can be included in the wire seal.

In this way, the wire seal seals the wire feed-through in the wall and at the same time protects the electronic circuit assembly from chemical contaminants. Thus, separate encapsulation of the electronic circuit assembly is not needed, and the number of separate parts is reduced. In addition, overall assembly efficiency is improved, and space is saved in the first environment.

According to an aspect of the invention, the wire seal can comprise the electronic circuit assembly, the electronic circuit assembly comprising a printed circuit board (PCB) and a PCB wiring connection. When the electronic circuit assembly comprises a PCB, a variety and plurality of individual electronic components can be arranged thereon, in accordance with the requirements. For example, the PCB can be designed according to the needs of the health monitor circuit of an electric machine.

According to an aspect of the invention, the electronic circuit assembly can comprise a memory chip, for example an electrically erasable programmable read-only memory (EEPROM) chip, arranged on the PCB. When data is stored in the memory chip, the data can be protected from environmental risk factors by being included in the wire seal. For example, calibration data for electric machine sensors can be stored in the memory chip and accessed together with the sensor output when the sensors are present in the second environment.

According to an aspect of the invention, the receptacle can be L-shaped and positioned in the slot such that the short portion of the receptacle is arranged in the first side of the wire seal housing and/or the long portion of the receptacle is arranged in parallel to the one or more wire ducts, wherein at least the short portion of the receptacle comprises an inlet to the interior of the receptacle for a wiring of the electronic circuit assembly. In this configuration, the receptacle is adapted to receiving a PCB longitudinally, taking up less space inside the wire seal. Thus, further space inside the wire seal is freed up for sealing-enhancing elements or devices, for example for sealing devices configured to seal the wire ducts.

According to an aspect of the invention, the electronic circuit assembly can be arranged in the interior of the receptacle such that the PCB extends along the long portion of the receptacle, and such that the PCB wiring connection is received through the inlet and extends along the short portion of the receptacle. In this arrangement, the PCB extends into the wire seal, and electronic components arranged on the PCB can be protected therein, while at the same time, the wiring connection is accessible from the first environment. Thus, the PCB wiring connection can conveniently be further connected in the first environment, for example to a switching device and data stored on a memory device on PCB can be accessed through the switching device.

According to an aspect of the invention, the receptacle can be cuboid-shaped and at least one side of the cuboid-shaped receptacle comprises an inlet to the interior of the receptacle for a wiring of the electronic circuit assembly. A cuboid-shaped receptacle is convenient for manual handling an insertion into the slot of the wire seal.

According to an aspect of the invention, the electronic circuit assembly can be arranged in the interior of the cuboid-shaped receptacle such that the PCB extends in parallel to the one or more wire ducts and the PCB wiring connection is received through the inlet. In this way, the cuboid-shaped receptacle can be positioned inside the slot such that the at least one side of the cuboid-shaped receptacle comprising the inlet is arranged substantially in parallel to the wire ducts, for example such that the inlet faces away from the first environment. Thus, the interior of the receptacle in which the PCB extends is further protected from environmental risk factors that may be present in the first environment.

According to an aspect of the invention, the PCB can be press-fit in the receptacle for further costefficiency of the assembly of the electronic circuit assembly with the receptacle. That is, the arrangement of the electronic circuit assembly in the interior of the receptacle requires fewer components and assembly steps.

According to an aspect of the invention, the receptacle can be filled with a potting material, in particular an epoxy-based potting material. Thus, when an electronic circuit assembly is arranged in the receptacle, the electronic circuit assembly is further protected against chemical contaminants and mechanical vibrations.

According to an aspect of the invention, wire seal can comprise a form-fitting device, in particular a snap-fitting device for the form-fitting, in particular snap-fitting, of the receptacle in the slot. This provides higher flexibility and adaptability for the assembly of the wire seal. For example, the receptacle may be inserted in the slot of the wire seal prior the installation of the wire seal in the wire feed-through to facilitate handling and transportation. Alternatively, the receptacle may be inserted in the slot of the wire seal after installation of the wire seal housing in the wire feed-through, to facilitate assembly with an electronic circuit assembly and/or connection of the electronic circuit assembly with a switching device.

According to an aspect of the invention, the form-fitting device can comprise at least one latching arm formed on an outer surface of the receptacle, and one or more corresponding depressions formed on an inner surface of the wire seal housing. In this configuration, the mechanical resilience of the latching arm can be configured such that an extremity of the latching arm is elastically bent until reaching the depression, firmly lodging the receptacle in the slot.

According to an aspect of the invention, the second side of the wire seal housing can comprise a distal surface of the slot, the distal surface of the slot comprising a depression matching the shape of a distal side of the receptacle. In this configuration, the matching of the depression in the distal surface of the slot can provide additional form-fitting stability to the arrangement of the receptacle in the slot. In particular, rotational displacements and/or vibrations can be further inhibited.

According to an aspect of the invention, the wire seal can further comprise one or more sealing joints, in particular O-rings, arranged along an outer surface of the wire seal housing, and/or a retaining element, arranged on an outer surface of the first side of the wire seal housing. The sealing joints and/or the retaining ring can further increase the sealing performance and mechanical stability of the arrangement of the wire seal in the slot.

According to an aspect of the invention, the wire seal further can comprise one or more wire terminals, each wire terminal being arranged in a corresponding wire duct. Preferably, the one or more wire terminals are crimpable wire terminals. The crimpable wire terminals can be arranged such that a crimping portion of the crimpable wire terminal is arranged towards the second environment and a connecting portion of the terminal is arranged towards the first environment. In this configuration, the wires can be crimped, soldered or otherwise attached to the wire terminals, and the manual handling of the wire seal is improved when the wire seal is assembled with the wires. That is, when the wire seal is assembled with the wires, the wires are firmly attached with the wire terminals arranged in the wire ducts, and the wires only protrude on one side of the seal. For example, a wire seal assembly comprising the wire seal and the wires attached to the wire terminals can be handled together and positioned in a wire feed-through from one side, for example from the second environment, and connected from another side, for example from the first environment.

According to an aspect of the invention, the wire seal can further comprise a micro-quadlock-system (MQS) connector configured to facilitate an electrical connection with the one or more wire terminals. In particular, the MQS connector can be arranged with the wire terminals arranged in the wire ducts, and thus an electrical connection with the wires attached to the wire terminals can be conveniently completed in one step by coupling with a corresponding MQS connector.

According to an aspect of the invention, the slot is at least partially, preferably entirely, filled with a potting material, in particular an epoxy-based potting material. The potting material filling the slot improves the sealing performance of the wire seal, and further protects the receptacle against chemical, vibrational or electromagnetic interference.

According to an aspect of the invention, the potting material filling at least partially the slot can be configured to bond the receptacle inside the wire seal housing. In this way, the potting material can firmly bond the receptacle in the slot, thus reducing the need for further form-fitting or frictionfitting means of the attachment of the receptacle in the slot.

The invention also relates to a method for assembling a wire seal assembly. The method for assembling a wire seal assembly comprises the steps of:
a) Providing a wire seal according to any one of the above-described aspects,
b) Feeding one or more wires, in particular sensor wires comprising corresponding sensor elements, preferably negative temperature coefficient (NTC) sensor elements, through the respective wire ducts of the wire seal housing, and
c) Sealing the one or more wires fed through the one or more respective wire ducts.

According to this method, a wire seal assembly can be assembled which benefits from the above-outlined advantages of the various aspects of the inventive wire seal and includes the wires for combined handling, facilitating a mounting the wire feed-through.

Preferably, step b) can comprise an attaching of the wires to wire terminals arranged in the wire ducts. This further improves the handling and installation of the wire seal assembly.

Preferably, step c) can comprise at least one, in particular at least two or each, of: filling the wire ducts and/or the slot with potting material; arranging single-wire seals in the wire ducts; and covering a second side opening of the wire ducts with wire duct covers. This can further improve the sealing performance of the wire seal and the wire seal assembly.

The object of the invention may also be achieved by means of a wire seal assembly comprising a wire seal according to any one of the above-outlined aspects, and further the one or more wires, in particular sensor wires comprising corresponding sensor elements, preferably NTC sensors, wherein each of the wires is fed through one of the wire ducts so as to connect the first environment and the second environment. The wire seal assembly benefits from the above-outlined advantages of the various aspects of the inventive wire seal and includes the wires for combined handling, facilitating a mounting of the wire feed-through.

According to one aspect of the wire seal assembly, the wire seal assembly can further comprise a wire duct seal device for the sealing of the feed-through of at least one of the one or more wires through a respective wire duct. In particular, the wire duct seal device can comprise at least one, preferably two or each, amongst: a single-wire seal arranged on the fed-through wire; a wire duct cover covering the second side of the wire ducts; and a potting material filling the wire duct. The wire duct seal device seals the wire ducts present in the wire seal, and thus further improves the sealing performance of the wire seal assembly.

According to one aspect of the wire seal assembly, the wire seal assembly can further comprise a potting material filling the wire duct, and a portion of the at least one of the one or more wires fed through the respective wire duct can be stripped of its wire-coating, in particular a portion enveloped by the potting material. A wire stripped of its wire-coating can have a higher adherence and material compatibility with the potting material. Therefore, the reliability and mechanical stability of the wire duct seal device can be increased.

The invention also relates to a method for sealing a wire feed-through in an electric machine frame wall. The method comprises the steps of:
a) Providing a wire seal assembly according to one of the above-described aspects;
b) Arranging the wire seal assembly in the wire feed-through such that the first side of the wire seal housing interfaces a first environment, and a second side of the wire seal housing interfaces the second environment, in particular such that the corresponding sensor elements, preferably NTC sensors, are located in the second environment;
c) Connecting the fed-through wires to a switching device in the first environment; and
d) Connecting the PCB wire connection to the switching device.

The invention further relates an electric machine assembly, comprising a wire seal assembly according to one of the above-described embodiments, and an electric machine frame, wherein the electric machine frame comprises a wall separating a first, preferably dry, environment, and a second, preferably oil-submerged, environment, the wall comprising a wire feed-through for the feeding of wires through the wall. The wire seal assembly is arranged in the wire feed-through such that the first side of the wire seal housing interfaces with the first environment and the second side of the wire seal assembly interfaces with the second environment.

This electric machine assembly benefits from the advantages of the above-outlined wire assembly and in particular allows for wires to be passed from a first, for example dry, environment, to a second, for example oil-submerged, environment, without losing sealing performance. In addition, the receptacle of the wire seal can hold a PCB that is protected from environmental risk factors, potentially reducing the number of parts and the space requirement in the first environment.

According to one aspect of the electric machine assembly, the wires can be sensor wires and comprise sensor elements, in particular temperature sensors, preferably NTC sensors. This allows for sensor elements to be installed in the second environment and the sensor signals to be acquired in the first environment while sealing the wire feed-through of the sensor wires.

According to one aspect of the electric machine assembly, the electric machine assembly can further comprise a switching device connected to the wires and to the electronic circuit assembly.

The above-described aspects, objects, features and advantages of the present invention will be more completely understood and appreciated by careful study of the following more detailed description of a presently preferred exemplary embodiment of the invention, taken in conjunction with accompanying drawings, in which:
Figure 1 shows an exploded view of a wire seal according to a first embodiment of the invention, together with wires.
Figure 2 shows a perspective, unexploded view of the wire seal of Figure 1 assembled with the wires.
Figure 3. shows a first cross-sectional view of the assembled wire seal of Figure 2.
Figure 4 shows a second cross-sectional view of the assembled wire seal of Figure 2.
Figure 5 shows an exploded view of a wire seal according to a second embodiment of the invention, together with wires.
Figure 6 shows a perspective, unexploded view of the wire seal of Figure 5 assembled with the wires.
Figure 7 shows a cross-sectional view of the wire seal of Figure 6 assembled with the wires.
Figure 8 shows a cross-sectional view of the wire seal of Figure 6 assembled with the wires and installed in a wire feed-through of a wall.
Figure 9 shows cross-sectional view of a wire seal according to a third embodiment of the invention, together with wires.
Figure 10 shows cross-sectional view of a wire seal according to a fourth embodiment of the invention, together with wires.

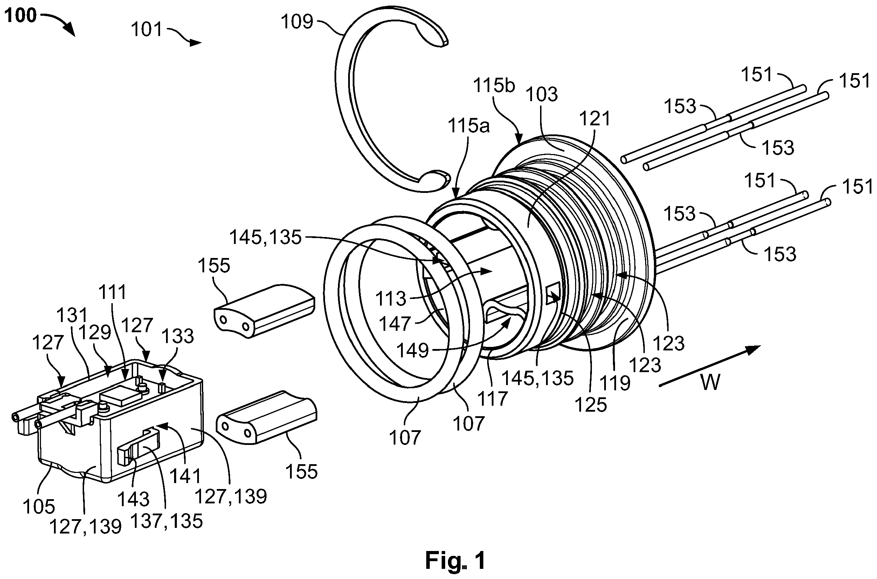

In the following detailed description of embodiments, identical reference signs identified in different figures and/or in different portions of the description of the figures relate to identical elements. Further, unless explicitly mentioned otherwise, the structural features of the objects illustrated in Figures 1 to 10 are not drawn to scale.

The technical features and their associated advantages or effects described in the following description of embodiments can be combined with or adapted to any aspects or embodiments of the invention, together or independently, yielding further possible embodiments or aspects of the invention.

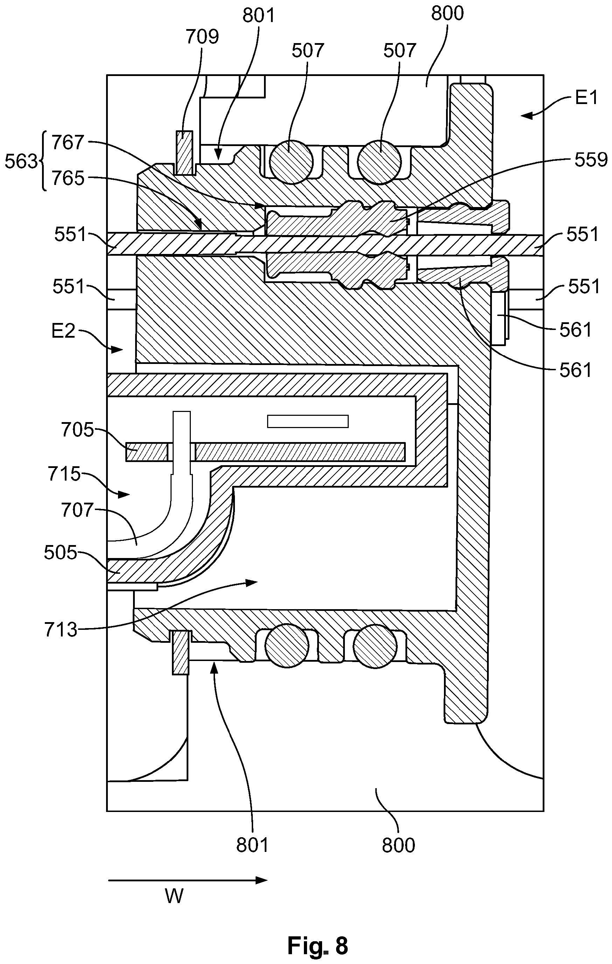

A wire seal according to a first embodiment of the invention will now be described with respect to Figures 1 to 4. Figure 1 shows an exploded view of a wire seal assembly 100, comprising the wire seal 101 according to the first embodiment. The wire seal 101 is a wire seal for the sealing of a feed-through of one or more sensor wires through an electric machine frame wall separating a first environment and a second environment, for example the wall 800 as shown in Figure 8.

The wire seal 101 shown in Figure 1 comprises a wire seal housing 103, a receptacle 105, sealing joints, here O-rings, 107, and a retaining element 109. Further, the wire seal 101 comprises an electronic circuit assembly 111 arranged in the receptacle 105. Preferably, the wire seal housing and/or the receptacle 105 are made of a plastic, in particular of a polybutylene terephthalate (PBT).

The wire seal housing 103 has a substantially tubular shape, extending along a wire direction W. A slot 113 is formed in the wire seal 101. In detail, the wire seal housing 103 is shaped to define the slot 113 extending inside the wire seal 101 along a wire direction W. The tubularly shaped wire seal housing 103 comprises, in the wire direction W, a first side 115a and a second side 115b, wherein the first side 115a is configured to interface with a first environment and the second side 115b is configured to interface with a second environment. The first side 115a comprises an opening 117 to the slot 113, the opening 117 is configured to connect the first environment and the slot 113.

The second side 115b of the wire seal housing 103 comprises a flange 119 protruding outwardly from an outer surface 121 of the wire seal housing 103. Further, circumferential grooves 123 are formed in the outer surface 121 and configured to accommodate sealing joints. In the present embodiment, two grooves 123 are formed in the outer surface 121 and configured to accommodate the sealing joints 107. Further, the first side 115a of the wire seal housing 103 comprises a circumferential wedge 125 formed in the outer surface 121 and configured to accommodate the retaining element 109.

The receptacle 105 is cuboid-shaped, that is, box-shaped or orthotope shaped, thus comprising six lateral sides. Five of the lateral sides 127 are without inlet and one of the lateral sides 129 comprises an inlet 131 to the interior 133 of the receptacle 105. The electronic circuit assembly 111 is arranged in the interior 133 of the receptacle 105. The interior 133 is filled with a potting material, in particular and epoxy-based potting material, covering the entirety of the electronic circuit assembly 111.

The wire seal 101 comprises a form-fitting device 135 for the form-fitting of the receptacle 105 in the slot 113. In particular, the form-fitting device 135 is a snap-fitting device for the snap-fitting of the receptacle in the slot 113. The form-fitting device 135 comprises two latching arms 137. Each latching arm 137 is formed on an outer surface 139 of a respective lateral side 127 of the receptacle 105. In particular, the latching arms 137 are formed in respective central regions 141 of the outer surfaces 139 of mutually opposed lateral sides 127 of the receptacle 105. Each latching arm 137 protrudes from the central region 141 and extends towards an extremity of the receptacle 105. Each latching arm 137 comprises a hook-shaped tip 143 configured to be lodged in a corresponding depression.

The form-fitting device 135 further comprises two corresponding depressions 145, each corresponding depression 145 being formed on an inner surface 147 of the wire seal housing 103. Specifically, the corresponding depressions 145 traverse the wire seal housing 103 from the inner surface 147 to the outer surface 121. The corresponding depressions 145 are configured to receive respectively a tip, in particular the hook-shaped tip 143, of a latching arm, in particular the latching arm 137.

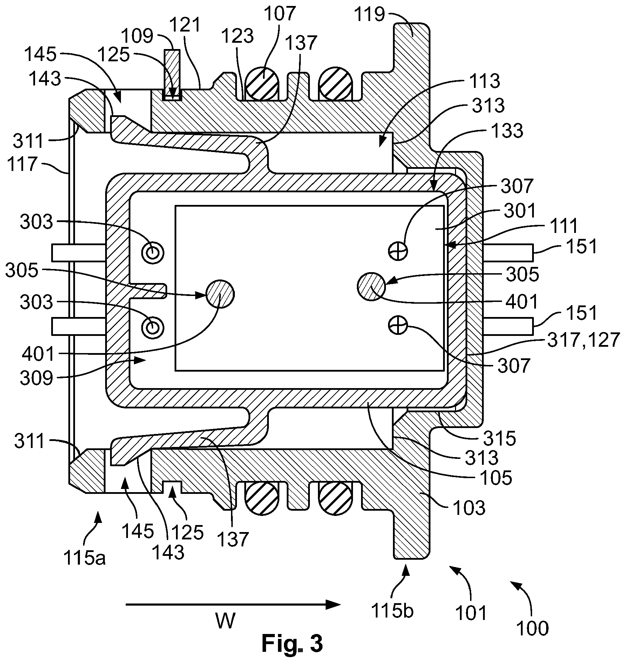

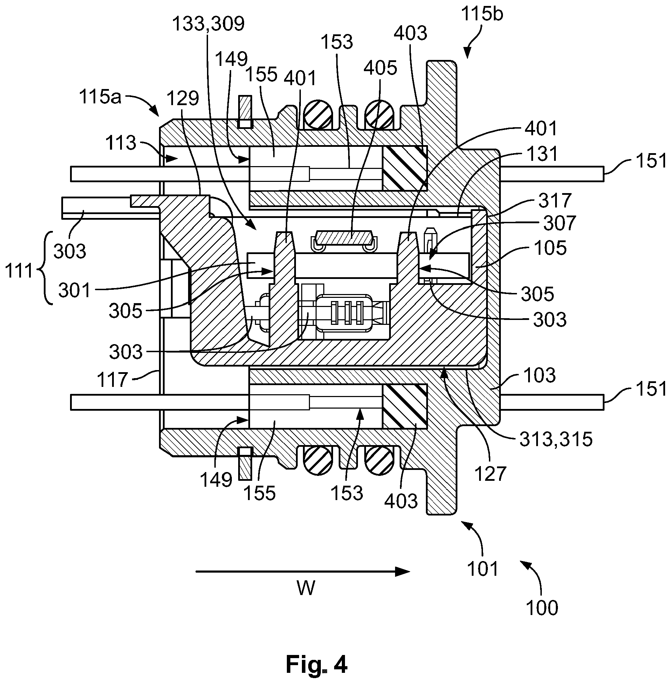

The wire seal housing 103 further comprises one or more, here two, internal pockets 149, whose purpose will be further understood in view of the following descriptions of Figures 3 and 4. The two internal pockets 149 are formed on two mutually opposing sides of the inner surface 147 of the wire seal housing 103. In particular, the internal pockets are arranged such that they extend along the wire direction W, having an opening in the first side 115a and extending towards the second side 115b of the wire seal housing 103.

The wire seal assembly 100 shown in Figure 1 comprises one or more, here four, wires 151, configured to be fed through the wire seal 101. For this purpose, the wire seal housing 103 comprises four wire ducts configured for the feed-through of the four wires 125 along the wire direction W. The wire ducts are not visible on Figure 1, but shall be described in the following with reference to further figures. In short, the wire ducts are arranged in two pairs of wire ducts, each pair of wire ducts feeding into a respective one of the two internal pockets 149.

The wires 151 are sensor wires. For example, each pair of wires 151 may be connected at an extremity to a sensor element, in particular temperature sensor, such as an NTC sensor. A portion 153 of each one of the wires 151 is stripped of its wire-coating, for better adherence with a potting material 155 configured to be filled into the internal pockets 149. The potting material 155 is a wire duct seal device configured to seal the wire ducts. The potting material 155 can be the same epoxy-based as the material filling the interior 133 of the receptacle 105.

The wire seal 101 is configured to seal the feed-through of the wires 151 through a wall of an electric machine frame wall separating a dry first environment and an oil-submerged second environment.

The wire seal housing 103 further comprises wire ducts extending through the wire seal housing 103 in the wire direction W, in order to connect the first environment and the second environment. The wire ducts are not visible on Figure 1 but will be described in the following in reference to further figures. The wire ducts are configured for the feed-through of wires, here four wires.

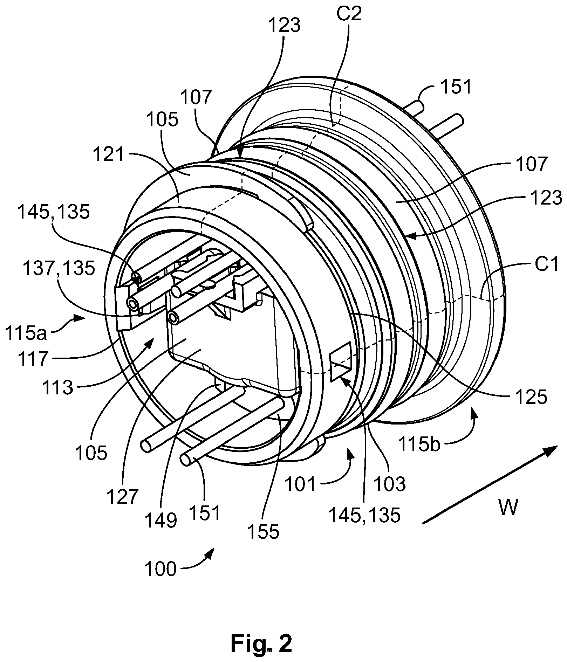

Figure 2 shows a perspective view of the wire seal assembly 100 of Figure 1, in an assembled state. The O-rings 107 are arranged along the outer surface 121 of the wire seal housing 103, lodged in the respective grooves 123. The retaining element 109 is arranged on the outer surface 121 in the first side 115a of the wire seal housing 103, lodged in the circumferential wedge 125. The receptacle 105 holding the electronic circuit assembly 111 is positioned, in particular slotted, in the slot 113. In detail, the receptacle is inserted through the opening 117 in the slot 113 such that the hook-shaped tips 143 of the latching arms 137 formed on the lateral sides 127 of the receptacle 113 are resiliently lodged, in particular snapped, in the corresponding depressions 145.

In addition, in the assembled state of Figure 2, the wires 151 are fed through the wire ducts and positioned such that the coating-stripped portions 153 are positioned in the internal pockets 149. Thus, the coating-stripped portions 153 are enveloped by the potting material 153 filling the internal pocket 149. The four sensor wires 151 thus connect a first environment interfacing with the first side 115a and a second environment interfacing with the second side 115b.

Figure 3 shows a cross-sectional view of the wire seal assembly 100 along the cross-sectional line C1 shown on Figure 2. Figure 3 shows the arrangement of the retaining element 109 and the sealing joints 107 along the outer surface 121 of the wire seal housing 103, respectively, in the wedge 125 and the grooves 123. In addition, Figure 3 also shows the tubular shape of the wire seal housing 103, defining the slot 113 with the opening 117.

In addition, the cross-sectional view of Figure 3 shows that the electronic circuit assembly 111 comprises a PCB 301 and a PCB wiring connection 303. The electronic circuit assembly 111 is arranged in the interior 133 of the receptacle 105 such that the PCB 301 extends in parallel to the wire direction W and the wire ducts.

The PCB 301 comprises two through-holes 305 for the press-fitting of the PCB 301 onto respective studs 401 of the receptacle 105, as shown on Figure 4. The PCB wiring connection 303 is connected to the PCB 301 at connection spots 307. A potting material 309, in particular comprising a same material as the potting material 155, fills the receptacle 105 and surrounds the PCB 301 as well as the PCB wiring connection 301.

The hook-shaped tips 143 of the latching arms 137 are lodged in the corresponding depressions 145, enabling a form-fitting, in particular snap-fitting, of the receptacle 105 in the slot 113. To facilitate an elastic displacement of the hook-shaped tips 143 during the insertion of the receptacle 105 in the slot 113, inward-facing chamfers 311 are formed at the opening 117 of the wire seal housing 103.

Further, Figure 3 shows that the distal surface 313 of the slot 113 at the second side 115b of the wire seal housing 103 comprises a depression 315, which matches the shape of a lateral side 127 of the receptacle 105. In particular, the depression 315 matches the shape of the distal side 317, that is, the distally-located side, of the receptacle 105, with respect to the opening 117.

Figure 4 shows a second cross-sectional view of the wire seal assembly 100 along the cross-sectional line C2 shown on Figure 2. As already described, the electronic circuit assembly 111 comprises a PCB 301 and a PCB wiring connection 303. The PCB 301 is press-fit in the receptacle 105 by fitting two internally protruding studs 401 thereof into the through-holes 305. The PCB wiring connection 303 is connected to the PCB 301 at the connection spots 307, and is guided out of the receptacle 105 through the inlet 131 and through the opening 117. Figure 4 further shows schematically a memory chip 405, here an EEPROM chip, arranged on the PCB 301 as part of the electronic circuit assembly 111.

The potting material 155 fills the two internal pockets 149 and envelops the coating-stripped portions 153 of the wires 151 fed through the wire seal housing 103. Optionally, a wire duct cover 403 can further be arranged on each wire 151 to further seal the wire duct against the second environment on the second side 115b.

The wire seal 101 seals the feed-through of the wires 151 through and at the same time protects the electronic circuit assembly 111 held in the integrated, form-fitted receptacle 105. In this configuration, the electronic circuit assembly 111 located in the wire seal 101 is further protected against environmental risk factors present in the first environment.

For example, when a microchip or digital memory device, such as an EEPROM chip, is required in the first environment, said microchip or digital memory device can be arranged on the PCB 301 like the memory chip 405 and connected via the PCB wiring connection 303, while being protected against chemical, vibrational or electromagnetic interference.

In the following descriptions of embodiments of the wire seal and the wire seal assembly, only differences with respect to the first embodiment will be described. Thus, features that are less or not described can be assumed to correspond to the features described with respect to the wire seal 101 and/or the wire seal assembly 100. The second to fourth embodiments are improvements or alternatives with respect to the first embodiment or each other, in accordance with the advantages outlined in the description of the invention above.

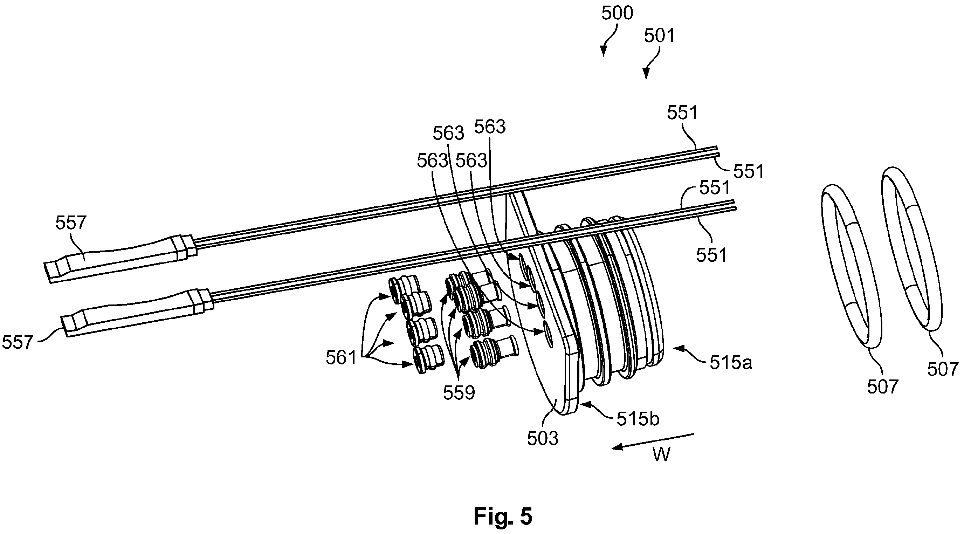

A wire seal according to a second embodiment of the invention will now be described with respect to Figures 5 to 8. Figure 5 shows an exploded view of a wire seal assembly 500, comprising the wire seal 501 according to the second embodiment. The wire seal 501 is also a wire seal for the sealing of a feed-through of one or more sensor wires through an electric machine frame wall separating a first environment and a second environment.

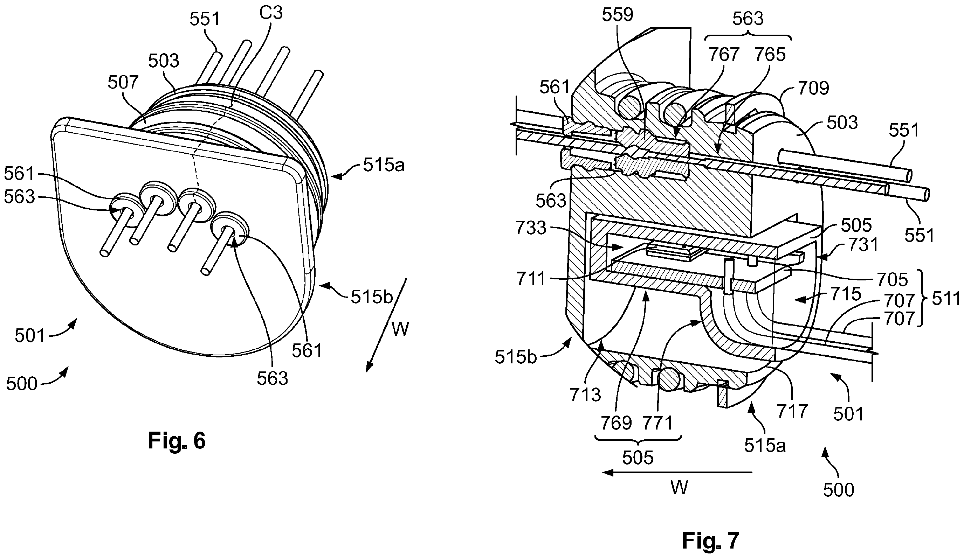

The wire seal 501 comprises a wire seal housing 503 having a first side 515a configured to interface a first environment, and a second side 515b configured to interface a second environment. Further, the wire seal 501 comprises sealing joints 507 as well as a receptacle 505 and an electronic circuit assembly 511, which are included inside the wire seal housing 503, as represented for example on Figure 7.

The wire seal assembly 500 comprises the wire seal 501, as well as four wires 551. The wires 551 are sensor wires. As represented in Figure 5, the wires 551 may optionally comprise sensor elements 557, here two NTC sensors, one for each pair of wires 551.

The wire seal 501 comprises a wire duct seal device comprising, for each of the four wires 551 (here four wires 551), a single-wire seal 559, and a wire duct cover 561. Each single-wire seal 559 and wire duct cover 561 is configured to seal a respective one of the wire ducts 563 formed in the wire seal housing 503.

Figure 6 shows the wire seal 501 and the wire seal assembly 500 in a perspective, unexploded view, facing a second side 515b of the wire seal housing 503. Each wire is fed through the wire seal 501 through a respective wire duct 563, and each wire duct cover 561 covers the entry to a respective wire duct 563 on the second side 515b. The wire ducts 563 are formed in the wire seal housing 503 in parallel and next to each other, along a substantially linear row. The arrangement of the wire ducts 563 along a substantially linear row contrasts with the arrangement of the wire ducts in the first embodiment, in which pairs of wire ducts are arranged on mutually opposing sides of the wire seal housing 103.

A cross-sectional view of the assembled wire assembly 500 according to the cross-sectional line C3 of Figure 6 is represented in Figure 7. The view of Figure 7 provides in particular a cross-sectional view of a wire duct 563. Each wire duct 563 has a narrow portion 765 in the first side 515a, and an enlarged portion 767 in the second side 515b. The enlarged portion 767 is configured to accommodate the single-wire seal 559 and the wire duct cover 561. An optional retaining element 709 may be included in the wire seal 501, as represented on Figure 7, arranged in analogous fashion to the retaining element 109 of the wire seal 101 of the first embodiment.

In detail, each single-wire seal 559 is arranged on a respective wire 551 such that when the wire 551 is assembled with the wire seal 501, that is, fed through the wire duct 563, the single-wire seal 559 is sealingly engaged in the enlarged portion 767 of the wire duct 563. Similarly, each wire duct cover 561 is arranged on a respective wire 551 such that when the wire 551 is assembled with the wire seal 501, that is, fed through the wire duct 563, the wire duct cover 561 covers the entry to the enlarged portion 767 of the wire duct 563.

The wire seal duct device of the wire seal 501, comprising here the single-wire seals 559 and the wire duct covers 561, seal the wire ducts 563 inside the wire seal 501. Therefore, in contrast to the wire seal 101 of the first embodiment, the here-above described wire seal 501 of the second embodiment does not comprise a potting material for the sealing of wire ducts 563. However, in variants, the wire duct seal device may additionally comprise a potting arranged in the wire ducts 563.

In one variant of the second embodiment, the wire duct seal device of the wire seal 501 can, instead of the wire duct cover 561, comprise a potting material filling the enlarged portion 767 of the wire duct 563. In another variant of the second embodiment, the wire duct seal device can, in addition to the single-wire seal 559 and the wire duct cover 561, comprise a potting material filling the enlarged portion 767 of the wire duct 563. In a further variant of the second embodiment, the wire duct seal device can comprise a potting material filling the entirety of the enlarged portion 767 of the wire duct 563, without any single-wire seal of wire duct cover. The potting material used in these variants can, for example, be the same potting material as the potting material 155 of the first embodiment.

Figure 7 shows that the receptacle 505 is held in a slot 713 formed in the wire seal 501 that extends in the wire direction Wfrom an opening 717 in the first side 515a towards the second side 515b. The receptacle 505 is form-fitted, in particular snap-fitted in the slot 713 with a form-fitting device, in particular a snap-fitting device, analogous to the form-fitting device of the first embodiment comprising latching arms and corresponding depressions, which shall thus not further be described.

The wire seal 501 of the second embodiment further differs from the wire seal 101 with respect to the shape of the receptacle 505 holding the electronic circuit assembly 511. According to the presently described second embodiment of the invention, the receptacle 505 has an L-shape instead of a cuboid-shape. The L-shaped receptacle 505 thus has a long portion 769 of the L-shape and a short portion 771 of the L-shape. The electronic circuit assembly 511 comprises, as described with respect to the first embodiment, a PCB 705 and PCB wiring connections 707. The electronic assembly 511 further comprises memory chip 711, in particular an EEPROM chip, arranged on the PCB 705.

The short portion 771 comprises an inlet 731 to the interior 733 of the receptacle. The inlet 731 is configured to receive the PCT wiring connections 707 for the wiring of the PCB 705. The receptacle 505 is positioned in the slot 713 such that the short portion 771 is arranged in the first side 515a of the wire seal housing 503, in particular along a direction orthogonal to the wire direction W, wherein the inlet 731 faces towards in the direction opposed to the wire direction W. At the same time, the receptacle 505 is also positioned in the slot 713 such that the long portion 769 is arranged in parallel to the wire direction W and in parallel to the wire ducts 563. In addition, in the present second embodiment, the receptacle 505 is filled with a potting material 715, preferably an epoxy-based potting material.

The wire seal assembly 500 can be assembled with a method for assembling a wire seal assembly according to another embodiment of the invention. The method starts with a step of providing the wire seal 501 described above with reference to Figures 5, 6 and 7. In a next step, the four wires 551, comprising corresponding NTC sensors 557, are fed each through a respective wire ducts 563 of the wire seal housing 503. Specifically, the wires 551 are fed through wire ducts 563 in the direction opposed to the wire direction W, first through the enlarged portion 767 in the second side 515b, then through the narrow portion 765 in the first side 515a, and out of the wire seal housing 503 on the first side 515a. In a further step, the wires 551 fed through the wire ducts 563 are sealed. For example, each wire 551 can be sealed by pushing the respective single-wire seal 559 and/or the respective wire duct cover 561, pre-mounted on the wires 551, into their respective positions in the enlarged portion 767 of the wire duct 563.

Figure 8 shows a cross-sectional view of the wire seal of Figures 6 and 7, assembled with the wires 551 and installed in a wire feed-through 801 of a wall 800. The wall is an aluminium electric machine frame wall that separates a first environment E1, in particular a dry environment of an electric machine, and a second environment E2, in particular an oil-submerged environment in an electric machine. The enlarged portion 767 of the wire ducts 563 open into the first environment E1 and the narrow portion 765 of the wire ducts 563 open into the second environment. The wire seal 501 seals the feed-through 801 of the sensor wires 551 through the electric machine frame wall 800.

The wire feed-through 801 in the wall 800 can be sealed with a method for sealing a wire feed-through in an electric machine frame wall according to a further embodiment of the invention. The method starts with a step of providing the wire seal assembly 500. In a next step, the wire seal assembly 500 is arranged in the wire feed-through 801 such that the first side 515a of the wire seal housing 503 interfaces a first environment E1, and a second side 515b of the wire seal housing 503 interfaces the second environment E2 and the NTC sensors 557 are located in the second environment E2.Then, the fed-through wires 551 are connected to a switching device in the first environment E1, and the PCB wire connection 707 is connected to said switching device. In this way, the wire feed-through 801 is sealed with good performance while at the same time, the switching device can be connected to the protected, integrated electronic circuit assembly 511 and may interact with memory chips thereof.

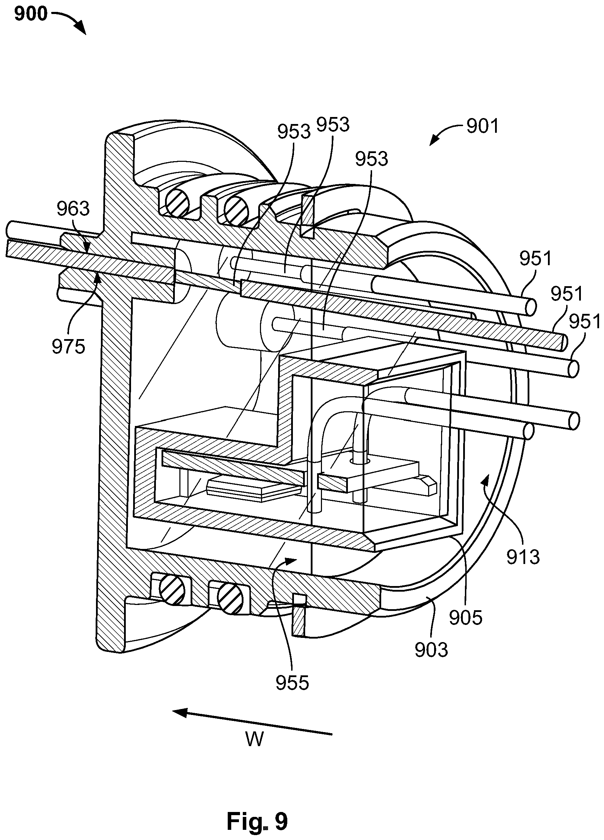

Figure 9 shows a cross-sectional view of a wire seal 901 of a wire seal assembly according to the third embodiment of the invention. The wire seal 901 differs from the wire seals 101, 501 in that the receptacle 905 is not form-fitted in the slot 913, by for example the form-fitting device 135. Instead, the slot 913 is entirely filled with a potting material 955, for example any one of the previously described potting materials155, 309, 715. The potting material bonds 955 the receptacle 905 to the wire seal housing 903.

In this embodiment, the wire ducts 963 comprise only a narrow portion 975 for the feeding-through of the wires 951. A portion of the wires 953 configured to be enveloped by the potting material 955 inside the slot 913 is stripped of wire-coating to improve adherence to the potting material 955 filling the slot 913, as already described with respect to the first embodiment.

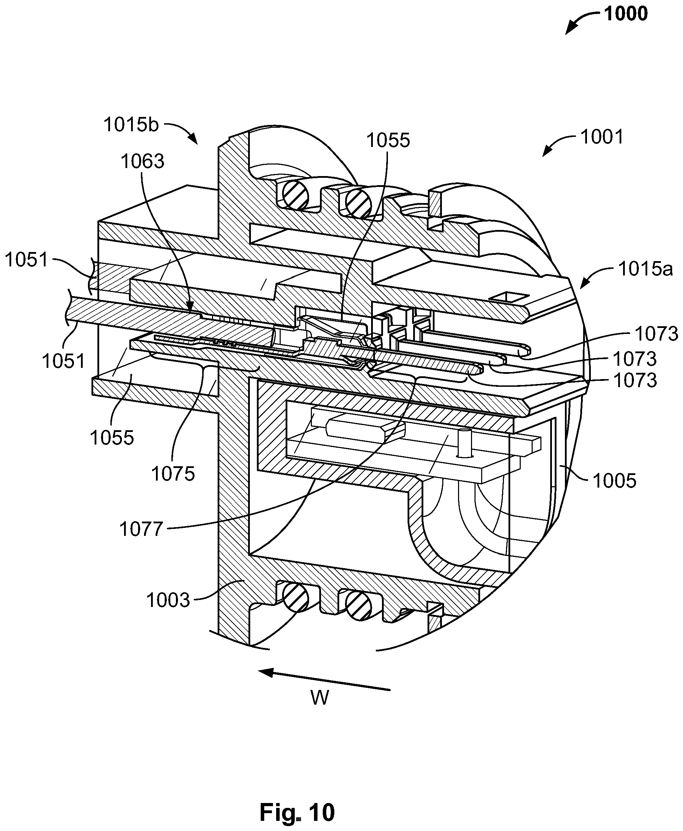

Figure 10 shows cross-sectional view of a wire seal 1001 according to a fourth embodiment of the invention. The wire seal 1001 differs from the wire seals 101, 501, 901 in that the wire seal 1001 further comprises, for each wire duct 1063, a crimpable wire terminal 1073 crimped on a corresponding wire 1051 and arranged in a corresponding wire duct 1063. In this embodiment, the wire terminals 1073 are male terminals, or pin terminals. Each wire terminal 1073 is arranged in its corresponding wire duct 1063 such that a crimping portion 1075 of the wire terminal 1073 is arranged towards the second side 1015b of the wire seal housing 1003 and a connecting portion 1077, that is, a pin, of the terminal 1073 is arranged towards the first side 1015a of the wire seal housing 1003. The wire seal assembly 1000 shown in Figure 10 comprises the wire seal 1001, as well as wires 1051 crimped to the crimping portions 1075 of the wire terminals 1073. The wire ducts 1063 are sealed by a wire duct seal device, here a potting material 1055 filling the wire ducts 1063.

Each one of the wire seal assemblies 100, 900, 1000 may also be used to seal the wall 800 according to the method for sealing a wire feed-through in an electric machine frame wall described above with respect to wire assembly 500. Similarly, each one of the wire seals 101, 901, 1001 may be manufactured according to the method of manufacturing a wire seal described above with respect to wire assembly 501.

### REFERENCE SIGNS

- 100: wire seal assembly
- 101: wire seal
- 103: wire seal housing
- 105: receptacle
- 107: sealing joint
- 109: retaining element
- 111: electronic circuit assembly
- 113: slot
- 115a: first side of the wire seal housing
- 115b: second side of the wire seal housing
- 117: opening
- 119: flange
- 121: outer surface of the wire seal housing
- 123: groove
- 125: wedge
- 127: lateral sides without inlet
- 129: lateral side with inlet
- 131: inlet to the interior
- 133: interior of the receptacle
- 135: form-fitting device
- 137: latching arm
- 139: outer surface of a lateral side
- 141: central region of an outer surfaces
- 143: hook-shaped tip
- 145: corresponding depression in the inner surface
- 147: inner surface of the wire seal housing
- 149: internal pocket
- 151: wire
- 153: coating-stripped portion of the wire
- 155: potting material for a wire duct
- 301: PCB
- 303: PCB wiring connection
- 305: through holes in the PCB
- 307: connection spots of the PCB wiring connection
- 309: potting material in the receptacle
- 311: inward-facing chamfers
- 313: distal surface of the slot
- 315: depression in the distal surface
- 317: distal lateral side of the receptacle
- 401: studs
- 403: wire duct covers
- 405: memory chip
- 500: wire seal assembly
- 501: wire seal
- 503: wire seal housing
- 505: receptacle
- 507: sealing joint
- 511: electronic circuit assembly
- 515a: first side of the wire seal housing
- 515b: second side of the wire seal housing
- 551: wire
- 557: sensor element
- 559: single-wire seal
- 561: wire duct cover
- 563: wire duct
- 800: wall
- 801: wall feed-through
- 705: PCB
- 707: PCB wiring connections
- 709: retaining element
- 711: memory chip
- 713: slot
- 715: potting material
- 717: opening
- 731: inlet to the interior of the receptacle
- 733: interior of the receptacle
- 765: narrow portion of a wire duct
- 767: enlarged portion of a wire duct
- 769: long portion
- 771: short portion
- 900: wire seal assembly
- 901: wire seal
- 903: wire seal housing
- 905: receptacle
- 913: slot
- 951: wire
- 953: coating-stripped portion of wire
- 955: potting material
- 963: wire ducts
- 975: narrow portion of a wire duct
- 1000: wire seal assembly
- 1001: wire seal
- 1003: wire seal housing
- 1005: receptacle
- 1015a: first side of the wire seal
- 1015b: second side of the wire seal
- 1051: wire
- 1055: potting material
- 1063: wire duct
- 1073: wire terminal
- 1075: crimping portion of the wire terminal
- 1077: connecting portion of the wire terminal
- C1, C2, C3: cross-sectional view line
- E1: first environment
- E2: second environment
- W: wire direction

## Claims

1. Wire seal for the sealing of a feed-through (801) of one or more wires (151, 551, 951, 1051) through a wall (800), in particular for the sealing of a feed-through of one or more sensor wires through an electric machine frame wall, the wall (800) separating a first environment (E1) and a second environment (E2),
the wire seal (101, 501, 901, 1001) comprising a wire seal housing (103, 503, 903, 1003) having a first side (115a, 515a, 1015a) configured to interface the first environment (E1), and a second side (115b, 515b, 1015b) configured to interface the second environment (E2),
wherein the wire seal housing (103, 503, 903, 1003) comprises one or more wire ducts (563, 963, 1063) connecting the first environment (E1) and the second environment (E2) and configured for the feed-through of at least one respective wire (151, 551, 951, 1051),
**characterized in that** a slot (113, 713, 913) is formed in the wire seal (101, 501, 901, 1001), and the first side (115a, 515a, 1 015a) of the wire seal housing (103, 503, 903, 1003) comprises an opening (117, 717) to the slot (113, 713, 913), the opening (117, 717) connecting the first environment (E1) and the slot (113, 713, 913),
the wire seal (101, 501, 901, 1001) further comprising a receptacle (105, 505, 905, 1005) positioned in the slot (113, 713, 913) and configured to hold an electronic circuit assembly (111, 511).

2. Wire seal according to claim 1, wherein the receptacle (505, 905, 1005) is L-shaped and positioned in the slot (713, 913) such that the short portion (771) of the receptacle (505, 905, 1005) is arranged in the first side (515a, 1015a) of the wire seal housing (503, 903, 1003) and/or the long portion (769) of the receptacle (505, 905, 1005) is arranged in parallel to the one or more wire ducts(563, 963, 1063),
wherein at least the short portion (771) of the receptacle (505, 905, 1005) comprises an inlet (731) to the interior (733) of the receptacle (505, 905, 1005) for a wiring of the electronic circuit assembly (511).

3. Wire seal according to claim 2, comprising the electronic circuit assembly (511), wherein the electronic circuit assembly (511) comprises a printed circuit board, PCB, (705) and a PCB wiring connection (707),
the electronic circuit assembly (511) being arranged in the interior (733) of the receptacle (505) such that the PCB (705) extends along the long portion (769) of the receptacle (503), and such that the PCB wiring connection (707) is received through the inlet (731) and extends along the short portion (771) of the receptacle (505).

4. Wire seal according to claim 1, wherein the receptacle (105) is cuboid-shaped and at least one side (129) of the cuboid-shaped receptacle (105) comprises an inlet (131) to the interior (133) of the receptacle (105) for a wiring of the electronic circuit assembly (111).

5. Wire seal according to claim 4, comprising the electronic circuit assembly (111), wherein the electronic circuit assembly (111) comprises a printed circuit board, PCB, (301) and a PCB wiring connection (303), the electronic circuit assembly (111) being arranged in the interior (133) of the receptacle (105) such that the PCB (301) extends in parallel to the one or more wire ducts and the PCB wiring connection (303) is received through the inlet (131), in particular wherein the PCB (301) is press-fit in the receptacle (105).

6. Wire seal according to any one of claims 1 to 5, wherein the receptacle (105, 505, 905, 1005) is filled with a potting material (133, 715), in particular an epoxy-based potting material.

7. Wire seal according to any one of claims 1 to 6, wherein wire seal (101, 501, 1001) comprises a form-fitting device (135), in particular a snap-fitting device for the form-fitting, in particular snap-fitting, of the receptacle (105, 505, 1005) in the slot (113, 713).

8. Wire seal according to claim 7, wherein the form-fitting device (135) comprises at least one latching arm (137) formed on an outer surface (139) of the receptacle (105, 505, 1005), and one or more corresponding depressions (145) formed on an inner surface (147) of the wire seal housing (103, 503, 1003).

9. Wire seal according to any one of claims 7 or 8, wherein the second side (115b) of the wire seal housing (103) comprises a distal surface (313) of the slot (113), the distal surface (313) of the slot (113) comprising a depression (315) matching the shape of a distal side (317) of the receptacle (105).

10. Wire seal according to any one of claims 1 to 9, further comprising:
one or more sealing joints (107, 507), in particular O-rings, arranged along an outer surface (121) of the wire seal housing (103, 503, 903, 1003), and/or
a retaining element (109, 709), arranged on an outer surface (121) of the first side (115a, 515a, 1015a) of the wire seal housing (103, 503, 903, 1003).

11. Wire seal according to any one of claims 1 to 10, further comprising one or more wire terminals (1073), each wire terminal (1073) being arranged in a corresponding wire duct (1063), in particular such that a crimping portion (1075) of the wire terminal (1073) is arranged towards the second environment (E2) and a connecting portion (1077) of the wire terminal (1073) is arranged towards the first environment (E1).

12. Wire seal according to any one of claims 1 to 11, wherein the slot (913) is at least partially, preferably entirely, filled with a potting material (955), in particular an epoxy-based potting material, in particular wherein the potting material (955) is configured to bond the receptacle (905) inside the wire seal housing (903).

13. Wire seal assembly comprising a wire seal (101, 501, 901, 1001) according to any one of claims 1 to 12, further comprising:
the one or more wires (151, 551, 951, 1051), in particular sensor wires comprising corresponding sensor elements (557), preferably NTC sensors, each of the wires (151, 551, 951, 1051) being fed through one of the wire ducts (563, 963, 1063) so as to connect the first environment (E1) and the second environment (E2), and
a wire duct seal device for the sealing of the feed-through of at least one of the one or more wires (151, 551, 951, 1051) through a respective wire duct (563, 963, 1063), wherein the wire duct seal device comprises at least one, preferably two or each, amongst:
a single-wire seal (559) arranged on the fed-through wire (551);
a wire duct cover (403, 561) covering the second side (115b, 515b) of the wire ducts (563); and
a potting material (155, 715, 1055) filling the wire duct (563, 963, 1063).

14. Wire seal assembly according to claim 13, the wire duct seal device comprising a potting material (133, 715, 1055) filling the wire duct (563, 963, 1063), in particular each of the wire ducts,
wherein a portion (153, 953) of the at least one of the one or more wires (151, 951) fed through the respective wire duct (963) is stripped of its wire-coating, in particular a portion enveloped by the potting material.

15. Method for sealing a wire feed-through (801) in an electric machine frame wall (80), comprising the steps of:
(a) Providing a wire seal assembly (100, 500, 900, 1000) according to claim 13 or 14;
(b) Arranging the wire seal assembly (100, 500, 900, 1000) in the wire feed-through (801) such that the first side (115a, 515a, 1015a) of the wire seal housing (103, 503, 903, 1003) interfaces a first environment (E1), and a second side (115b, 515b, 1015b) of the wire seal housing (103, 503, 903, 1003) interfaces the second environment (E2) , in particular such that the corresponding sensor elements (557), preferably NTC sensors, are located in the second environment (E2);
(c) Connecting the fed-through wires (151, 551, 951, 1051) to a switching device in the first environment (E1); and
(d) Connecting the PCB wire connection (303, 707) to the switching device.
